# EUROPEAN PATENT SPECIFICATION

(11) **EP 4 283 662 B1**
(45) Date of publication and mention of the grant of the patent: **26.03.2025**
(21) Application number: 22174896.5
(22) Date of filing: 23.05.2022
(51) Int. Cl.: H01L 21/48, H01L 23/498, H01L 23/14, H01L 23/373

(54) **METHOD OF ATTACHING A TERMINAL TO A METAL SUBSTRATE STRUCTURE FOR A SEMICONDUCTOR POWER MODULE**
VERFAHREN ZUM BEFESTIGEN EINES ANSCHLUSSES AN EINER METALLSUBSTRATSTRUKTUR FÜR EIN HALBLEITERLEISTUNGSMODUL
PROCÉDÉ DE FIXATION D'UNE BORNE SUR UNE STRUCTURE DE SUBSTRAT MÉTALLIQUE POUR UN MODULE DE PUISSANCE SEMI-CONDUCTEUR

(43) Date of publication of application: 29.11.2023
(73) Proprietor: Hitachi Energy Ltd, 8050 Zürich (CH)
(72) Inventor: GUILLON, David, 8857 Vorderthal (CH); BAYER, Martin, 5036 Oberentfelden (CH); ROESCH, Andreas, 79730 Murg (DE); SALVATORE, Giovanni A., 34170 Gorizia (IT); FISCHER, Fabian, 5400 Baden (CH)
(74) Representative: Epping - Hermann - Fischer

(56) References cited:
- EP-A1- 2 757 586
- EP-A1- 3 958 305
- US-A1- 2011 304 985
- US-A1- 2016 126 209
- US-A1- 2019 006 265
- US-A1- 2021 017 084
- US-A1- 2021 400 838

## Description

The present disclosure is related to a method for attaching a terminal to an insulated metal substrate structure for a semiconductor power module. The present disclosure is further related to a semiconductor power module.

EP 2 757 586 A1 discloses a method for attaching a terminal to an insulated metal substrate structure.

Conventional insulated metal substrates form technology for low and medium power semiconductor packages with low insulation requirements and low thermal resistance requirements simultaneously. Terminals are attached to the insulated metal substrate and there is a need for a reliable and cost-efficient connection of the terminals on the insulated metal substrate.

Embodiments of the present disclosure relate to a method for attaching a terminal to a metal substrate structure that can contribute to a cost saving semiconductor power module and that enables reliable functioning even for high voltage power module applications with enhanced reliability requirements.

According to an embodiment, a method for attaching a terminal to an insulated metal substrate structure for a semiconductor power module comprises providing at least one terminal and providing the insulated metal substrate structure with a metal top layer, a metal bottom layer and an isolating resin layer arranged between the metal top layer and the metal bottom layer. The method further comprises providing and coupling a sinter layer to a top surface of the metal top layer and/or a bottom surface of the at least one terminal to form a sintering area for the at least one terminal. The method further comprises coupling the at least one terminal to the metal top layer by means of sintering with a sinter tool such that the sinter layer is arranged between the metal top layer and the at least one terminal and connects the at least one terminal to the metal top layer.

Due to the described method realization of sintered joining connections on an insulated metal substrate are possible which can contribute to a stable and reliable functioning of a semiconductor power module even for high voltage power module applications. The method further contributes to secure attachment of terminals on insulated metal substrates by sintering with a reduced damage risk to the isolating resin layer, for example. Insulated metal substrate structures realize a cost-effective technology for power semiconductor modules with low insulation and low thermal resistance requirements and enable large size power modules for low, medium and high voltage range applications. The described method may also contribute to realization of sintered joining connections on a metal substrate structure enabling stable and reliable functioning of a semiconductor power module with such a metal substrate.

It is a finding in the context of the present disclosure that alternative joining techniques such as welding techniques can provide reliable joining connections but are seen to be critical with respect to a stable process on substrates with an isolating resin sheet without any damage of the substrate structure. Especially ultrasonic welding is accompanied by a strong impact of thermal and mechanical stress on substrate structures due to large friction and pressure between a terminal foot and a substrate. Here a resin sheet, which is clearly softer than ceramics, but also brittle because of the incorporation of inorganic filler material, is strongly endangered by deformation and crack formation. A corresponding deformation of an underlying soft layer can occur in an ultrasonic welding process, e.g. for an ultrasonically bonded thick copper wire on a thin soldered copper platelet. A soft solder layer below the copper wire undergoes a strong deformation similar to a soft resin sheet of an insulated metal substrate when welding a terminal foot on it.

Ultrasonic welding experiments on insulated metal substrates confirm these expectations of the generation of severe damages in the isolating resin sheet during the welding process, so that ultrasonic welding on insulated metal substrate substrates seems to be very difficult or even impossible. At least, there is a risk that cannot be neglected that an interface of the isolating resin sheet comprise defects below the welded terminal feet due to welding techniques. Additionally, it can be considered that laser welding or other welding techniques may be also critical with respect to damaging of the substrate and especially the resin sheet due to strong thermal impact and introduced mechanical stress. A resin sheet is strongly endangered by deformation and crack formation. Furthermore, there is a risk of delamination of the metallization from the resin sheet layer. Corresponding failure modes can occur when applying ultrasonic welding or laser welding, or other welding techniques of terminal feet on a circuit metallization of an insulated metal substrate.

By use of the described method for manufacturing a metal substrate structure with one or more sintered terminals it is possible to counteract the aforementioned adverse effects due to the sintering of the terminals and the metal top layer. The sintering process enables to reduce mechanical and thermal stress acting on the lower layers of the metal substrate structure. A risk of crack or damage formation in the resin layer and delamination of the metal top layer can be reduced and a stable semiconductor power module is feasible that enables reliable functioning even for high voltage power module applications in a voltage range of 0.5 kV up to 10.0 kV, for example.

According to an embodiment of the method, the step of providing and coupling the sinter layer comprises providing a substance with predetermined sinter particles, and applying the substance e.g. by means of printing onto the top surface of the metal top layer and thereby forming the sintering area with a preformed sinter layer. The substance represents a sinter raw material, for example in the form of a film or paste which can be printed on a predetermined position on the metal top layer. The sinter material and thus the sinter layer can be provided in a predetermined manner as a pumpable liquid or viscous paste comprising at least one of silver, copper, gold and nickel, or other applicable metal as main material. Alternatively or additionally, a sinter raw material can be provided as a solid sheet or a preform which is attached on the substrate and/or the terminal. Alternatively or additionally, the sinter material can be another material applicable by means of sintering. The sinter raw material can be pre-applied at a given position on the insulated metal substrate structure to have to have a prepared structure.

The sinter material can comprise micrometer and/or nanometer particles of the main component which enable to form a firmly or materially bonded connection between the one or more terminals and the metal top layer. The sinter layer or the sinter material to form the sinter layer can comprise a material composition with polymers and/or a solvent, binder or agents in the raw material which are removed during the sintering process. In view of the sintered connection between the one or more terminals and the insulated metal substrate structure the sinter layer realizes a kind of a more or less porous paste of typically pure metal with more or less porous shape that is distinguishable from the material of the terminal and the metal top layer which may be realized by bulk copper or aluminum.

Sintering realizes a process of compacting and forming a solid mass of material by heat and/or pressure without melting the joint partner to the point of liquefaction. A sintering tool can be used to apply pressure on the terminal and/or to apply heat to bake the terminals and the metal top layer together with the sinter layer between them. Accordingly, sintering can be described as baking of particles together, whereas the joining is done by a diffusion process between the particles.

According to a further embodiment of the method sintering is done with high pressure up to 20 MPa acting on the at least one terminal. For example, high pressure is set in the range of 5 MPa up to 25 MPa. For example, sintering of the terminals and the metal top layer can be done with a high pressure up to 10 MPa or 15 MPa. Usually, relative high pressure acting on the joint partners enable a reliable quality of the sintering joint also depending on porosity of the sinter material. In this case, the sintered layer has low porosity and/or high compactness. Thus, the pressure used for sintering is given in coordination with the joint partners and the chosen sinter material.

According to a further embodiment of the method sintering is done with low pressure up to 2 MPa acting on the at least one terminal. For example, sintering of the terminals and the metal top layer can be done with a low pressure of 0.2 MPa, 0.5 MPa, 1 MPa or 1.5 MPa. A choice of sintering pressure also depends on a sensitivity on pressure of the joint partners. In this case, especially the resin sheet of the substrate is sensitive. For example, the one or more terminal belongs to electronics such as a chip and high pressure should not be used to reduce a risk of damaging the chip and/or the resin layer. If a low pressure is used for sintering, the terminal can be fixed or held in position using a rubber or a positioning tool which may also belong to a sintering tool. Moreover, sintering of the terminals and the metal top layer can be done pressure-less such that no additional pressure or a very low pressure is used during sintering.

According to a further embodiment of the method, the step of providing the at least one terminal comprises providing the at least one terminal with a given stress relief structure. The stress relief structure can comprise at least one of a spring structure, a thinned portion and a recess implemented to the one or more terminals to beneficially affect the sintering process.

According to the method of the invention, the step of providing the at least one terminal comprises providing a group or plurality of terminals coupled to a housing block and/or a leadframe. The terminals can be coupled or directly connected to the leadframe or the housing block. The method further comprises coupling the housing block and/or the leadframe with the terminals to the metal substrate structure such that a predetermined pressure for sintering is acting on the plurality of terminals applied by the coupling. Thus, a sintering pressure may be applied by the coupled housing block itself. Nevertheless, a pressure can be exposed on a terminal foot of a respective terminal to contribute to a reliable sintering process.

The one or more terminals can be made of or comprise at least one of copper, copper alloy, aluminum and aluminum alloy or any other applicable metals or other conductive materials. The metal top layer can also be made of or comprise at least one of copper, copper alloy, aluminum and aluminum alloy or any other applicable metals or other conductive materials. According to a further embodiment of the method, the metal top layer is provided with a coating layer on a top surface that is configured to face the sinter material or the bottom surface of the at least one terminal during sintering. Alternatively or additionally, the at least one terminal is provided with a coating layer on the bottom surface that is configured to face sinter layer or the metal top layer of the metal substrate structure during sintering. Such a coating can be intended for facilitation of a joining connection between the terminal, the sinter material film and/or the substrate metallization realized by the metal top layer.

One or more of the aforementioned coating layers of the terminal and the metal top layer can be made of or comprise a noble metal, like nickel and/or silver and/or gold, and/or one or more other metals. Such a coating can contribute to prevent oxidation and/or to improve conditions of the sintering process and/or may also protect the resin layer of the metal substrate structure. The respective coating can partially or completely cover a predetermined surface of the bottom surface of the terminal or of the top surface of the metal top layer. Moreover, the respective coating may comprise one or more layers.

The isolating resin layer forms a dielectric layer and can be realized as a pre-preg sheet which is assembled between two metal plates on top and bottom forming the metal top layer and the metal bottom layer. Such metallization sheets or plates are bonded to the dielectric resin layer by the lamination process, for example. A required metallization structure of the metal top layer can then be done by subsequent steps of masking and etching processes to locally remove conductive metal, creating the final metallization structure. Alternatively, the top metallization structure can be formed by cutting or stamping, for example before the formation of the finished metal substrate structure.

Alternatively, the resin layer can be formed by molding. With respect to such a molded dielectric layer, a molding substance realizes a pumpable molding substance with predetermined material properties. The molding substance is a liquid or viscous raw material of the resin layer to be formed. For example, the molding substance is an epoxy and/or ceramic based liquid. Alternatively or additionally, the raw material of the dielectric layer may be a thermosetting or a thermoplastic resin material such as polyamide, PBT, PET. Alternatively or additionally, the raw material of the dielectric layer may comprise inorganic filler, for example based on a ceramic material, for improved thermal conductivity and/or CTE adjustment with respect to the metal top layer and/or the metal bottom layer. For example, the molded dielectric layer comprises a resin based dielectric material with ceramic filling material, e.g. Al2O3, AlN, BN, Si3N4 or SiO2. For example, the dielectric layer is an epoxy with filler. The dielectric layer can be also based on other materials suitable for transfer, injection or compression molding or other applicable molding technologies such as bismaleimide, cyanate ester, polyimide and/or silicones. Alternatively or additionally, the dielectric layer can include a ceramic material and/or hydroset material or a material combination of two or more of the aforementioned components.

The aligning of the metal top layer and the metal bottom layer relative to each other with a predetermined distance in between will substantially predetermine the later thickness of the molded dielectric layer. For example, the thickness is defined along a stacking direction of the metal substrate structure which may present a z-direction. However, the alignment can also be done in the perpendicular x- and y-directions for proper positioning, e.g. of the metal pattern with respect to the x- and y-direction. For example, the alignment can be realized by placing the metal top layer onto a release film or liner or another fixation, for example in a mold chase of a molding tool. This enables to precisely position the provided metallization structure of the metal top layer relative to the metal bottom layer and can be useful if the metal top layer comprises separate metal pads due to different potentials of operation, for example. In case of lamination, a thickness of a resin layer is given by the thickness and the behavior of the laminated layer.

The thickness of the isolating resin layer can have a value of 50 µm up to 300 µm. A thickness of the metal top layer can have a value of 0.15 mm up to 0.5 mm or up to 2.00 mm. The terminal can comprise an L-shape with an elongated terminal body extending mainly in the stacking direction and a terminal foot extending mainly in lateral directions substantially perpendicular to the stacking direction. The terminal foot may form a plate with a thickness of 0.5 mm up to 1.5 mm with respect to the stacking direction. The thickness of the terminal foot and/or the sintering area formed by the sintering process may be smaller compared with other portions of the terminal, for example. For example, a lateral size or area of the terminal foot can be larger or smaller than a corresponding extension of the sinter layer. The one or more terminals can realize main terminals for power connections or auxiliary terminals for electrical signal connections or signal wiring of the semiconductor power module.

The at least one terminal can also comprise a structure prepared for improved sintering. Such a sintering structure can be realized by a roughed or thinned area, by one or more slots, grooves and/or recesses in a terminal foot of the terminal, for example. Such a sintering structure can be prepared on a top and/or bottom side of the respective terminal and/or on the top surface of the metal top layer. Specific terminal structures can beneficially affect the sintering process and can contribute to the formation of the materially or firmly bonding sintering joint.

By use of the described manufacturing or attaching methods for joining the terminals to the insulated metal substrate it is possible to counteract adverse effects. For example, a risk of cracks, deformation or formation of other damages , especially in the isolating resin layer of the metal substrate structure, can be reduced and a stable semiconductor power module is feasible at low cost that enables reliable functioning of the semiconductor power module with an enhanced durability or life time.

Finally, it is pointed out that all the proposed features and methods can be used solely, but also a combination of two or more.

According to an embodiment, the at least one terminal comprises a given stress relief structure with at least one of a spring structure, a thinned portion and a recess, for example. Thus, a respective terminal can have a spring section or an elastic portion realizing a buffer or stress relief structure that can contribute to protection of the resin layer against mechanical and/or thermal impact.

The semiconductor power module comprises a plurality of terminals which on the one hand are coupled to a housing block and/or a leadframe and which on the other hand are connected respectively to the top surface of the metal top layer by means of sintering. The housing block can be formed as a resin body and the plurality of terminals can be embedded in the resin body partially.

The semiconductor power module can further comprise a heat sink which is coupled with the metal bottom layer of the metal substrate structure to dissipate heat during operation of the semiconductor power module. The metal bottom layer forms a base of the metal substrate structure and can be made of or comprise copper, aluminum and/or a corresponding alloy. Thus, the semiconductor power module can comprise a separate heat sink. An additional heat sink may also be made of copper, aluminum and/or a corresponding alloy or of composite material like aluminum-silicon-carbide or magnesium-silicon-carbide. Alternatively or additionally, the metal bottom layer of the metal substrate structure can act as a heat sink itself and can be configured to comprise ribs, fins, or protrusion on the bottom side with respect to the stacking direction, for example, to provide a beneficial heat dissipation. The metal bottom layer can further act as a baseplate of the semiconductor power module.

The semiconductor power module including the metal substrate structure can be further partly or completely encapsulated by resin prepared by molding or potting or dielectric gel. Moreover, the semiconductor power module can comprise two or more embodiments of the aforementioned buffer structures. The semiconductor power module can further include electronics, for example chips, integrated circuits, sensors and/or other discrete devices.

The proposed process of sintering terminal feet onto the surface of the insulated metal substrate structure has a strong potential to reduce the mechanical and thermal impact of the joining process on the resin isolating sheet compared with welding techniques, for example. A sintering process without damaging the heat- and pressure-sensitive resin layer is possible making the use of this comparably cost-effective substrate technology interesting. Such an attaching or manufacturing method for an insulated metal substrate structure can be interesting for large power modules and power modules for higher voltage classes with enhanced reliability requirements. However, the described method allows to manufacture metal substrate structures and semiconductor power modules that can be applied to miscellaneous products, for example low voltage industrial and automotive products operating in a voltage range of 1.7 kV or below, but also for products in higher voltage classes. A significant cost-down may be possible, when replacing a standard setup of ceramic substrates being soldered to a baseplate by an insulated metal substrate. On the one hand material costs may be reduced, and on the other hand several other process steps like the joining process between substrate and baseplate in the power module assembly are not needed and can be removed from a process flow.

Exemplary embodiments are explained in the following with the aid of schematic drawings and reference numbers. The figures show:
- Figures 1-3: embodiments of a method for attaching a terminal to a metal substrate structure of semiconductor power module in a respective side view; and
- Figure 4: a flow chart for a method for attaching an embodiment of the terminal to the metal substrate structure.

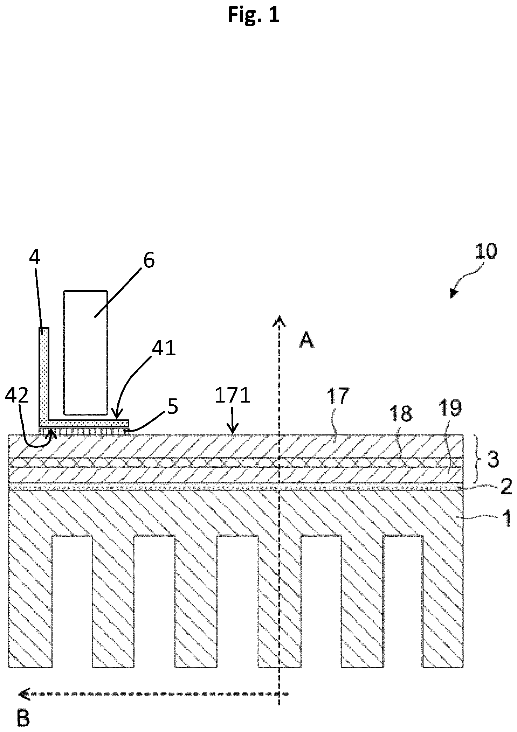

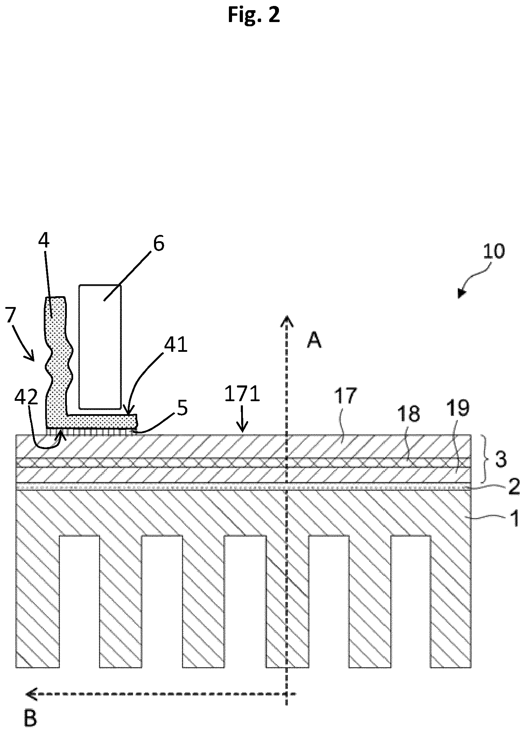

The embodiments described in relation to figures 1 and 2 do not form part of the invention but are useful to understand it.

The accompanying figures are included to provide a further understanding. It is to be understood that the embodiments shown in the figures are illustrative representations and are not necessarily drawn to scale. Identical reference numbers designate elements or components with identical functions. In so far as elements or components correspond to one another in terms of their function in different figures, the description thereof is not repeated for each of the following figures.

For the sake of clarity elements might not appear with corresponding reference symbols in all figures possibly.

Figure 1 illustrates a side view of an embodiment of a method step for attaching a terminal foot or terminal 4 to an insulated metal substrate structure 3 of a semiconductor power module 10 for a semiconductor device. The semiconductor power module 10 comprises the insulated metal substrate structure 3 with a metal top layer 17, a metal bottom layer 19 and an isolating resin layer 18 arranged between the metal top layer 17 and the metal bottom layer 19 with respect to a stacking direction A.

The semiconductor power module 10 further comprises a cooler or heat sink 1 with a fin or rib structure which is coupled with the metal substrate structure 3 by means of a bonding layer 2 and/or a layer of thermal interface material. With respect to the illustrated stacking direction A the one or more terminals 4 are to be coupled to the metal top layer 17 and underneath the heat sink 1 is coupled with the metal bottom layer 19 via the bonding layer 2.

In this respect terms like "above", "under", "top", "upper" and "bottom" refer to an orientation or direction as illustrated in the figures and with respect to the staking direction A. Thus, a height or thickness of the described elements is related to the stacking direction A whereas a lateral direction B is orientated perpendicular to the stacking direction A (see Figs. 1-3).

A thickness of the isolating resin layer 18 can be between 100-200 µm, for example. A thickness of the circuit metallization that is formed by the metal top layer 17 can be between 0.15-2.00 mm. A thickness of the metal bottom layer 19 which may realize a baseplate can be between 1-5 mm and may also be configured to dissipate heat from the metal substrate structure 3 and the semiconductor power module 10. The resin layer 18 can comprise an epoxy resin material, but also another thermosetting resin or other types of resin like thermoplastic resin are possible. The resin layer 18 may be formed as a resin sheet or a pre-preg sheet that is assembled or laminated between the two metal layers 17, 19.

Alternatively or additionally, the metal substrate structure 3 comprises the resin layer 18 formed by means of molding, for example by means of injection, transfer or compression molding. The resin of the resin layer can contain inorganic filler, ceramic material, e.g. AlN, Si3N4, BN, Al2O3 or SiO2. The metal bottom layer 19 can be made of or comprise copper and/or aluminum and/or a corresponding alloy. The circuit metallization formed by the metal top layer 17 can be made of or comprise copper and/or aluminum and/or a corresponding alloy. Moreover, the metal top layer 17 may be coated partially or completely and a corresponding coating of the circuit metallization can be made of or comprise a noble metal, such as nickel and/or gold and/or silver, and/or other metals.

The semiconductor power module 10 further comprises a sinter layer 5 that may comprise silver or copper and that is arranged between the metal top layer 17 and the at least one terminal 4. The sinter layer 5 is used to connect a bottom surface 42 of the terminal 4 to a top surface 171 of the metal top layer 17 by means of sintering. The sinter layer 5 can have a thickness of 20µm-50µm or even up to 250µm. The sinter layer 5 can be formed thinner in view of reducing costs and can be pre-applied to one or both of the joining partners.

Sintering enables joining of the main or auxiliary terminal 4 to the insulated metal substrate structure 3, but also to corresponding substrate structures basing on alternative technologies like a stamped and molded metal substrate. In contrast to welding techniques, where a strong thermal and/or mechanical impact makes the joining process very difficult, only a moderate impact of static mechanical pressure and moderately enhanced temperature must be considered when joining a terminal foot on the circuit metallization or the metal top layer 17 by sintering.

As shown in the Figs. 1-3, one or more terminal feet can be joined to the top surface 171 of the insulated metal substrate structure 3 by a sintering process. A pressure and/or heat for performing the sintering process can be applied by a sintering tool 6 acting on a top surface 41 of the terminal 4, for example. However, heat can also be applied to the complete insulated metal substrate structure 3 and the assembling setup for manufacturing the semiconductor power module 10. The sintering tool 6 can further enable precise positioning or holding of the terminal 4 in its given position during the sintering process. The sintering connection is provided by a sinter material configured to form the sinter layer 5 with particles of micron or sub-micron size of silver, copper, or any other material applicable for a sintering process.

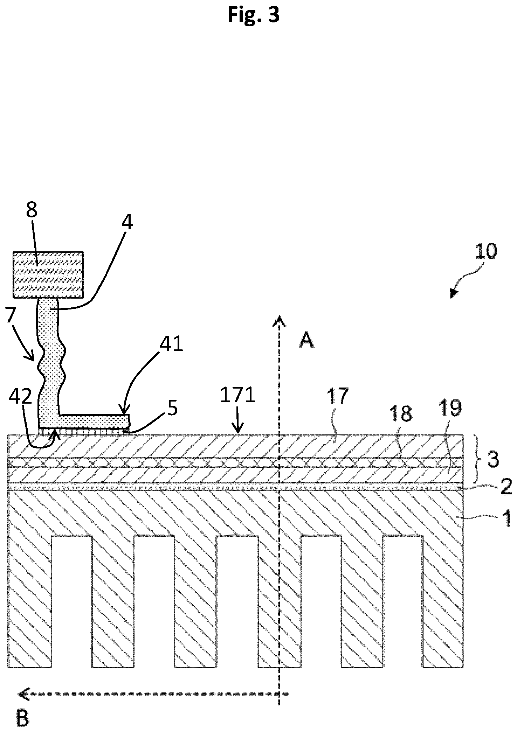

The sintering process can be used for a single terminal 4 or for groups of multiple terminals. Also a simultaneous sintering process for multiple terminals being arranged in a common terminal or housing block or leadframe is possible (see Fig. 3). For a further improvement to counteract mechanical stress exposed to the joining connections and to contribute to an enhanced reliability, the terminal 4 may have a stress relief structure 7, e.g. with the aim of a compensation of possible vibrations or of a mismatch in the thermal expansion coefficient or for compensation of mechanical or geometrical tolerances in the housing block or terminal structure without enhanced stress (see Fig. 2).

The terminal 4 can be made of or comprise copper, aluminum and/or a corresponding alloy and may realize a main or an auxiliary terminal of the semiconductor power module 10. Moreover, the terminal 4 can comprise a coating layer which partially or completely covers the top surface 41 and/or the bottom surface 42 of terminal 4. Such a coating layer can beneficially affect the sintering process and/or can protect the surface(s) of the terminal 4 from oxidation and may be made of or comprise a noble metal, such as nickel, gold, silver, and/or other metals. The coating can also comprise one or more layers of such materials.

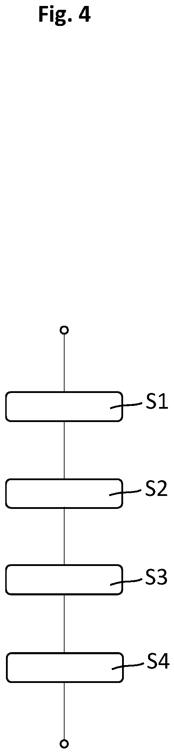

Steps of the method for attaching the terminal 4 to the metal substrate structure 3 can follow the flow chart as shown in Figure 4. In a step S1 the at least one terminal 4 is provided. The terminal 4 can be provided comprising one or more coating layers on its top and/or bottom surface 41, 42.

In a step S2 the metal substrate structure 3 is provided with the metal top layer 17, the metal bottom layer 19 and the isolating resin layer 18 arranged therebetween. A coating layer may be also available on the top surface 171 of the metal substrate structure 3 at least locally.

In a step S3 a sinter material can be provided to form the sinter layer 5. For example, the sinter material includes micro-particles and/or nano-particles comprising silver and/or gold provided as a substance or raw material. The sinter material can then be applied onto the top surface 171 of the metal top layer 17 and/or the bottom surface 42 of the terminal 4 by means of printing and thereby forming a sintering area the sinter layer 5 is intended to be formed. The sinter material can also be a solid sheet or preform, which is attached to one of the joining partners.

In a further step S4 the terminal 4 is pressed towards the metal top layer 17 with a given pressure and heating of the assembled terminal 4, the metal top layer 17 and the sinter material in between is started. In this respect, a given pressure and heat can be applied simultaneously or the pressure is applied before or after introducing heat to the setup. For example, pre-heating can be performed prior going into a sintering press. Such a pre-heating process can introduce a temperature set slightly lower of the temperature used during the sintering process.

Thus, so to speak the sinter material is baked and transformed into the sinter layer 5 which connects the bottom surface 42 of the terminal 4 to the top surface 171 of the metal top layer 17 by means of sintering.

The one are more terminals 4 can realize main or auxiliary terminals and are joined by their respect terminal feet to the top surface 171 of the insulated metal substrate 3 by means of sintering. The sintering connections between terminal feet and the top surface 171 are prepared from particles of silver, copper, or other materials, which are applicable for a sintering process. The described sinter particles can have diameters in the micron or sub-micron range. Depending on type and material of the terminal, the terminal foot has a thickness of 0.5-1.5 mm. For an improved sintering process or a protection of the joining partners e.g. against oxidation, the substrate top surface 171 and/or the top surface 41 and/or the bottom surface 42 of the terminal foot may be coated by a metal layer e.g. made from nickel, silver and/or gold.

There can be several setups of terminals 4 being mounted to the top surface 171 of the metal substrate structure 3: First, one or more single terminals 4 can be individually joined to the top surface 171 by means of sintering. Second, multiple terminals 4 may be arranged in a group as it is the situation in a leadframe, where terminals feet are simultaneous joined to the substrate metallization which is realized by the metal top layer 17. Finally, a simultaneous sintering of multiple terminals 4, which are arranged in a common terminal or housing block 8 is possible (see Fig. 3). Here at least parts of several terminals 4 are embedded in a common resin body of the housing block 8, for example. The housing block 8 may form a part of the module housing of the semiconductor power module 10, which is prepared by a molding process.

Additionally, one or more stress relief structures 7 may be implemented to the one or more terminals 4 (see Fig. 2 and 3). Such a stress relief structure may contribute to a compensation of thermal expansion or to compensate vibrations or other forces or for compensation of mechanical or geometrical tolerances in the housing or terminal structure without enhanced stress, to which the joining connection is exposed. The stress relief structure 7 of a respective terminal 4 may be realized by different designs, e.g. one or more spring portions, thinned portions and/or openings / holes in a terminal shaft.

In contrast to a conventional joining technique using an ultrasonic welding process, for example, a mechanical and thermal impact on the resin isolating layer 17 can be reduced by means of sintering. Additionally, for example to form a very stable and reliable connection the one or more terminals 4 can be coupled to the metal top layer 17 by means of soldering, gluing, dry contacting, welding and/or any other applicable joining method used for fixation onto the circuit metallization realized by the metal top layer 17. The terminal 4 can also be coupled to the metal top layer 17 by means of sintering beforehand forming the metal substrate structure 3 to further prevent mechanical impact on the isolating resin layer 18.

There are several options for the realization of the sintering process itself depending on the joining partners and/or the sinter material, for example:
- Sintering can be processed with high pressure using a pressure of about 20 MPa or a pressure value from 5 MPa up to 25 MPa.
- Sintering can be processed with low pressure using a pressure of about 0.5 MPa or a pressure value from 0.1 MPa up to 5.0 MPa. In the case of a terminal or housing block 8, where multiple terminals 4 are arranged in a resin body, which can be part of a module housing, the pressure is applied by the housing block 8 itself
- Pressure-less sintering
- heating can be processed with a temperature in the range of 200 up to 270°C or up to 290°C or up to 300°C.

Heating and maintaining the heat can be realized by an oven, a hot plate and/or a heated sintering tool for heating the sinter raw material and the joining partners from one or more sides. Pressure can be applied by a mechanical pressing element which can also comprise a positioning and/or fixation structure formed in coordination with the respective terminal design to be sintered. The sinter material can comprise micrometer and/or nanometer sinter particles wherein larger particles may be used with higher sintering pressure also depending on porosity requirements and the intended application of the semiconductor power module 10.

For example, the sinter raw material is provided as a paste-like substance with silver and/or copper particles of nanometer size. Then, the sinter layer 5 can be formed by applying relatively low pressure from 0.1 MPa up to 5.0 MPa and applying heat with a temperature of 200-300°C for a time range of 1-10 minutes or up to 20 minutes. Thus, alternatively or additionally the paste-like substance can comprise silver and/or copper particles of micrometer size.

Alternatively, the sinter raw material can be provided as a silver- and/or copper-foil with silver and/or copper particles of micrometer size, for example. Then, the sinter layer 5 can be formed by applying relatively high pressure from 5 MPa up to 25 MPa and applying heat with a temperature of 200-300°C for a time range of 1-10 minutes or up to 20 minutes. A choice of silver, gold, nickel or copper particles can be made depending on the costs, the sintering process and its temperature and pressure parameters and/or the design and the intended application of the semiconductor power module 10 and/or the requirements with respect to the sintering joint and the porosity of the sinter layer 5.

The embodiments shown in the Figures 1 to 2 as stated represent exemplary embodiments of the improved metal substrate structure 3, the semiconductor power module 10 and the manufacturing method for; therefore, they do not constitute a complete list of all embodiments. Actual arrangements and methods may vary from the embodiments shown in terms of metal substrate structures 3 and semiconductor power modules 10, for example.

### Reference signs

- 1: heat sink
- 2: bonding layer
- 3: metal substrate structure
- 4: terminal
- 41: top surface of the terminal
- 42: bottom surface of the terminal
- 5: sinter layer
- 6: sinter tool
- 7: stress relief structure
- 8: housing block
- 10: semiconductor power module
- 17: metal top layer
- 171: top surface of the metal top layer
- 18: resin layer
- 19: metal bottom layer

- A: stacking direction
- B: lateral direction
- S(i): steps of a method for attaching a terminal to a metal substrate structure

## Claims

1. A method for attaching a terminal (4) to an insulated metal substrate structure (3) for a semiconductor power module (10), comprising:
- providing a plurality of terminals (4) coupled to a housing block (8) and/or a leadframe,
- providing the insulated metal substrate structure (3) with a metal top layer (17), a metal bottom layer (19) and an isolating resin layer (18) arranged between the metal top layer (17) and the metal bottom layer (19),
- providing and coupling a sinter layer (5) to a top surface (171) of the metal top layer (17) and/or a respective bottom surface (42) of the terminals (4) to form a respective sintering area for the terminals (4), and
- coupling the terminals (4) to the metal top layer (17) by means of sintering such that the respective sinter layer (5) is arranged between the metal top layer (17) and the associated terminal (4) and connects the terminals (4) to the metal top layer (17), wherein the coupling of the terminals (4) comprises coupling the housing block (8) and/or the leadframe to the insulated metal substrate structure (3) such that a predetermined pressure for sintering is acting on the plurality of terminals (4) applied by the coupling.

2. The method according to claim 1, wherein the step of providing and coupling the sinter layer (5) comprises:
- providing a substance or sinter raw material with predetermined sinter particles, and
- applying the substance or sinter raw material by means of printing onto the top surface (171) of the metal top layer (17) and thereby forming the sintering area and preforming the sinter layer (5).

3. The method according to any one of the preceding claims, wherein the sinter layer (5) comprises at least one of silver, copper, gold and nickel.

4. The method according to any one of the preceding claims, wherein sintering is done with high pressure up to 25 MPa acting on the at least one terminal (4).

5. The method according to any one of the claims 1-3, wherein sintering is done without pressure or with low pressure up to 2 MPa acting on the at least one terminal (4).

6. The method according to any one of the preceding claims, wherein the step of providing the at least one terminal (4) comprises:
providing the at least one terminal (4) with a given stress relief structure (7), wherein the stress relief structure (7) comprises at least one of a spring structure, a thinned portion and a recess.

7. The method according to any one of the preceding claims, wherein the at least one terminal (4) and/or the metal top layer (17) are provided comprising at least one of copper, copper alloy, aluminum and aluminum alloy.

8. The method according to any one of the preceding claims, wherein the step of providing the at least one terminal (4) and/or the insulated metal substrate structure (3) comprises:
providing a coating layer on the bottom surface (42) of the at least one terminal (4) and/or on the top surface (171) of the metal top layer (17), wherein the bottom surface (42) and the top surface (171) are configured to face each other during sintering, and wherein the coating layer of the at least one terminal (4) and/or the metal top layer (17) comprises one or more layers with at least one of nickel, silver and gold.

9. The method according to any one of the preceding claims, wherein the step of providing the insulated metal substrate structure (3) comprises:
- providing a molding substance,
- aligning the metal top layer (17) and the metal bottom layer (19) relative to each other with a predetermined distance in between, and
- bringing in the provided molding substance between the aligned metal top layer (17) and the metal bottom layer (19) and thereby forming the isolating resin layer (18) by means of molding.

## Patentansprüche

1. Verfahren zum Befestigen eines Anschlusses (4) an einer isolierten Metallsubstratstruktur (3) für ein Halbleiterleistungsmodul (10), Folgendes umfassend:
- Bereitstellen mehrerer Anschlüsse (4), die mit einem Gehäuseblock (8) und/oder einem Leiterrahmen verbunden sind,
- Bereitstellen der isolierten Metallsubstratstruktur (3) mit einer Metalldeckschicht (17), einer Metallbodenschicht (19) und einer isolierenden Harzschicht (18), die zwischen der Metalldeckschicht (17) und der Metallbodenschicht (19) angeordnet ist,
- Bereitstellen und Verbinden einer Sinterschicht (5) mit einer oberen Oberfläche (171) der Metalldeckschicht (17) und/oder einer jeweiligen Bodenfläche (42) der Anschlüsse (4), um einen jeweiligen Sinterbereich für die Anschlüsse (4) auszubilden, und
- Verbinden der Anschlüsse (4) mit der Metalldeckschicht (17) mittels Sintern, so dass die jeweilige Sinterschicht (5) zwischen der Metalldeckschicht (17) und dem zugehörigen Anschluss (4) angeordnet ist und die Anschlüsse (4) mit der Metalldeckschicht (17) verbindet, wobei das Verbinden der Anschlüsse (4) Verbinden des Gehäuseblocks (8) und/oder des Leiterrahmens mit der isolierten Metallsubstratstruktur (3) umfasst, so dass ein vorbestimmter Druck zum Sintern auf die Vielzahl der Anschlüsse (4) wirkt, der durch das Verbinden angewendet wird.

2. Verfahren nach Anspruch 1, wobei der Schritt des Bereitstellens und Verbindens der Sinterschicht (5) Folgendes umfasst:
- Bereitstellen einer Substanz oder eines Sinterrohstoffs mit vorbestimmten Sinterpartikeln und
- Aufbringen der Substanz oder des Sinterrohstoffs mittels Drucken auf die obere Oberfläche (171) der Metalldeckschicht (17) und dadurch Ausbilden der Sinterfläche und Vorformen der Sinterschicht (5).

3. Verfahren nach einem der vorhergehenden Ansprüche, wobei die Sinterschicht (5) mindestens entweder Silber, Kupfer, Gold oder Nickel umfasst.

4. Verfahren nach einem der vorhergehenden Ansprüche, wobei Sintern mit hohem Druck bis zu 25 MPa durchgeführt wird, der auf den mindestens einen Anschluss (4) wirkt.

5. Verfahren nach einem der Ansprüche 1 bis 3, wobei Sintern ohne Druck oder mit niedrigem Druck bis zu 2 MPa durchgeführt wird, der auf den mindestens einen Anschluss (4) wirkt.

6. Verfahren nach einem der vorhergehenden Ansprüche, wobei der Schritt des Bereitstellens des mindestens einen Anschlusses (4) Folgendes umfasst:
Bereitstellen des mindestens einen Anschlusses (4) mit einer gegebenen Spannungsentlastungsstruktur (7), wobei die Spannungsentlastungsstruktur (7) mindestens entweder eine Federstruktur, einen verschwächten Abschnitt oder eine Vertiefung umfasst.

7. Verfahren nach einem der vorhergehenden Ansprüche, wobei der mindestens eine Anschluss (4) und/oder die Metalldeckschicht (17) bereitgestellt sind, die mindestens entweder Kupfer, Kupfer-Legierung, Aluminium oder Aluminium-Legierung umfassen.

8. Verfahren nach einem der vorhergehenden Ansprüche, wobei der Schritt des Bereitstellens des mindestens einen Anschlusses (4) und/oder der isolierten Metallsubstratstruktur (3) Folgendes umfasst:
Bereitstellen einer Beschichtung auf der Bodenfläche (42) des mindestens einen Anschlusses (4) und/oder auf der oberen Oberfläche (171) der Metalldeckschicht (17), wobei die Bodenfläche (42) und die obere Oberfläche (171) eingerichtet sind, um beim Sintern einander zugewandt zu sein, und wobei die Beschichtung des mindestens einen Anschlusses (4) und/oder der Metalldeckschicht (17) mindestens eine Schicht mit mindestens entweder Nickel, Silber oder Gold umfasst.

9. Verfahren nach einem der vorhergehenden Ansprüche, wobei der Schritt des Bereitstellens der isolierten Metallsubstratstruktur (3) Folgendes umfasst:
- Bereitstellen einer Formsubstanz,
- Ausrichten der Metalldeckschicht (17) und der Metallbodenschicht (19) relativ zueinander mit einem vorbestimmten Abstand dazwischen und
- Einbringen der bereitgestellten Formsubstanz zwischen der ausgerichteten Metalldeckschicht (17) und der Metallbodenschicht (19) und dadurch Ausbilden der isolierenden Harzschicht (18) mittels Formen.

## Revendications

1. Procédé destiné à fixer une borne (4) à une structure de substrat métallique isolé (3) pour un module semi-conducteur de puissance (10), comprenant :
- l'obtention d'une pluralité de bornes (4) couplées à un bloc de boîtier (8) et/ou une grille de connexion,
- l'obtention de la structure de substrat métallique isolé (3) avec une couche métallique supérieure (17), une couche métallique inférieure (19) et une couche de résine isolante (18) disposée entre la couche métallique supérieure (17) et la couche métallique inférieure (19),
- l'obtention et le couplage d'une couche à fritter (5) à une surface supérieure (171) de la couche métallique supérieure (17) et/ou une surface inférieure respective (42) des bornes (4) pour former une zone de frittage respective pour les bornes (4), et
- le couplage des bornes (4) à la couche métallique supérieure (17) par frittage de telle sorte que la couche à fritter respective (5) soit disposée entre la couche métallique supérieure (17) et la borne associée (4) et relie les bornes (4) à la couche métallique supérieure (17), dans lequel le couplage des bornes (4) comprend le couplage du bloc de boîtier (8) et/ou de la grille de connexion à la structure de substrat métallique isolé (3) de telle sorte qu'une pression prédéterminée pour le frittage agisse sur la pluralité de bornes (4), appliquée par le couplage.

2. Procédé selon la revendication 1, dans lequel l'étape d'obtention et couplage de la couche à fritter (5) comprend :
- l'obtention d'une substance ou d'un matériau à fritter brut avec des particules à fritter prédéterminées, et
- l'application de la substance ou du matériau à fritter brut par impression sur la surface supérieure (171) de la couche métallique supérieure (17) et ainsi la formation de la zone de frittage et la préformation de la couche à fritter (5).

3. Procédé selon l'une quelconque des revendications précédentes, dans lequel la couche à fritter (5) comprend au moins un métal parmi l'argent, le cuivre, l'or et le nickel.

4. Procédé selon l'une quelconque des revendications précédentes, dans lequel le frittage est effectué avec une forte pression allant jusqu'à 25 MPa agissant sur l'au moins une borne (4) .

5. Procédé selon l'une quelconque des revendications 1 à 3, dans lequel le frittage est effectué sans pression ou avec une faible pression allant jusqu'à 2 MPa agissant sur l'au moins une borne (4).

6. Procédé selon l'une quelconque des revendications précédentes, dans lequel l'étape d'obtention de l'au moins une borne (4) comprend :
l'obtention de l'au moins une borne (4) avec une structure de relaxation des contraintes donnée (7), dans lequel la structure de relaxation des contraintes (7) comprend au moins un élément parmi une structure de ressort, une partie amincie et une encoche.

7. Procédé selon l'une quelconque des revendications précédentes, dans lequel l'au moins une borne (4) et/ou la couche métallique supérieure (17) sont obtenues comprenant au moins un composé parmi le cuivre, un alliage de cuivre, l'aluminium et un alliage d'aluminium.

8. Procédé selon l'une quelconque des revendications précédentes, dans lequel l'étape d'obtention de l'au moins une borne (4) et/ou de la structure de substrat métallique isolé (3) comprend :
l'obtention d'une couche de revêtement sur la surface inférieure (42) de l'au moins une borne (4) et/ou sur la surface supérieure (171) de la couche métallique supérieure (17), dans lequel la surface inférieure (42) et la surface supérieure (171) sont conçues pour se faire face pendant le frittage, et dans lequel la couche de revêtement de l'au moins une borne (4) et/ou de la couche métallique supérieure (17) comprend une ou plusieurs couches avec au moins un métal parmi le nickel, l'argent et l'or.

9. Procédé selon l'une quelconque des revendications précédentes, dans lequel l'étape d'obtention de la structure de substrat métallique isolé (3) comprend :
- l'obtention d'une substance de moulage,
- l'alignement de la couche métallique supérieure (17) et de la couche métallique inférieure (19) l'une par rapport à l'autre avec une distance prédéterminée entre elles, et
- l'insertion de la substance de moulage obtenue entre la couche métallique supérieure (17) et la couche métallique inférieure (19) alignées et ainsi la formation de la couche de résine isolante (18) par moulage.
